# EUROPEAN PATENT APPLICATION

(11) **EP 4 626 203 A1**
(43) Date of publication of application: **01.10.2025**
(21) Application number: 24809954.1
(22) Date of filing: 29.01.2024
(51) Int. Cl.: H10K 85/50

(54) **SOLAR CELL, SOLAR CELL MODULE, AND ELECTRIC DEVICE**

(30) Priority: 23.05.2023 CN 202310587850
(71) Applicant: Contemporary Amperex Technology Co., Limited, Ningde, Fujian 352100 (CN)
(72) Inventor: LIN, Xiangling, Ningde, Fujian 352100 (CN); SU, Shuojian, Ningde, Fujian 352100 (CN); LI, Hanfang, Ningde, Fujian 352100 (CN); CHEN, Changsong, Ningde, Fujian 352100 (CN); LIU, Zezheng, Ningde, Fujian 352100 (CN); ZHANG, Fan, Ningde, Fujian 352100 (CN); CHEN, Guodong, Ningde, Fujian 352100 (CN); GUO, Yongsheng, Ningde, Fujian 352100 (CN)
(74) Representative: Frick, Robert
(86) International application number: PCT/CN2024/074374
(87) International publication number: WO 2024/239704

(57) **Abstract**

The present application provides a solar cell, a solar cell module and an electrical device. The solar cell includes a light absorption layer containing a plurality of perovskite compound grains. In at least one cross section of the light absorption layer perpendicular to a layer thickness direction, a number-based cumulative distribution rate of perovskite compound grains with a long diameter D of 1 µm to 6 µm is ≥ 90%. The light absorption layer of the present application contains perovskite compound grains with a long grain diameter of 1 µm to 6 µm in at least one cross section perpendicular to the layer thickness direction, with the number-based cumulative distribution rate of the perovskite compound grains being ≥ 90%.

## Description

### CROSS-REFERENCE TO RELATED APPLICATIONS

The present application claims priority to Chinese Patent Application No. 202310587850.5, filed on May 23, 2023 and entitled "SOLAR CELL, SOLAR CELL MODULE AND ELECTRICAL DEVICE", which is incorporated herein by reference in its entirety.

### TECHNICAL FIELD

The present application relates to the technical field of solar cell devices, and in particular to a solar cell, a solar cell module and an electrical device.

### BACKGROUND

Green and environmentally friendly recyclable and renewable energy is the most important direction for the development of energy technology in future. Solar cells based on perovskite photovoltaic cells, which can directly convert solar energy into electric energy under sunlight, are a new energy technology that is attracting increasing attention.

For perovskite photovoltaic cells, how to improve the overall performance is the most important research direction.

### SUMMARY

An object of the present application is to provide a solar cell which can improve the internal electric field strength of the solar cell, increase the open circuit voltage, and improve the energy conversion efficiency thereof. An object of the present application is also to provide a solar cell module including the solar cell and an electrical device, to obtain improved internal electric field strength and open circuit voltage and improved energy conversion efficiency.

In a first aspect, an embodiment of the present application provides a solar cell, including a light absorption layer.

The light absorption layer includes a plurality of perovskite compound grains. In at least one cross section of the light absorption layer perpendicular to a layer thickness direction, and a number-based cumulative distribution rate of the perovskite compound grains with a long diameter D of 1 µm to 6 µm is ≥ 90%.

According to the technical solution of the embodiment of the present application, the light absorption layer includes perovskite compound grains with a long grain diameter of 1 µm to 6 µm in at least one cross section perpendicular to the layer thickness direction, with the number-based cumulative distribution rate of the perovskite compound grains being ≥ 90%.

This increases the crystal quality of the perovskite compound grains in the light absorption layer, including the overall grain size, and can obtain the properties, such as an efficient light capture capacity, an ultrafast carrier transport capacity and ion migration inhibition. During the power generation process of solar cells, the overall grain size of the perovskite compound grains is larger, which reduces the number of grain boundaries between the perovskite compound grains, reduces or avoids the interference of interface defects, and promotes the charge separation at the interface, thereby improving the comprehensive performance of solar cells, including an energy conversion efficiency.

In addition, the open circuit voltage is affected by the minimum energy required to excite electrons and the energy gap of the semiconductor material itself. If the energy gap is relatively large, the open circuit voltage will increase, and the number of photons required will also decrease. During the power generation process of solar cells, the larger grain size of perovskite compound grains is conducive to having a suitable energy gap, improving light capture capacity, and reducing the number of photons required, which is beneficial to increasing the open circuit voltage.

In any embodiment of the present application, in at least one cross section of the light absorption layer perpendicular to the layer thickness direction, the number-based cumulative distribution rate of the perovskite compound grains with a long diameter D of 2.0 µm to 5.0 µm is ≥ 75%.

In any embodiment of the present application, in at least one cross section of the light absorption layer perpendicular to the layer thickness direction, the number-based cumulative distribution rate of the perovskite compound grains with a long diameter D of 2.0 µm to 3.5 µm is ≥ 50%.

In any embodiment of the present application, in at least one cross section of the light absorption layer perpendicular to the layer thickness direction, the number-based cumulative distribution rate of the perovskite compound grains with a long diameter D of more than or equal to 3.5 µm is 5%-30%.

In any embodiment of the present application, in at least one cross section of the light absorption layer perpendicular to the layer thickness direction, the number-based cumulative distribution rate of the perovskite compound grains with a long diameter D of 2.5 µm to 3.0 µm is ≥ 60%.

In any embodiment of the present application, in at least one cross section of the light absorption layer perpendicular to the layer thickness direction, the number-based cumulative distribution rate of the perovskite compound grains with a long diameter D of 1.0 µm to 2.5 µm is 20%-40%.

In any embodiment of the present application, in at least one cross section of the light absorption layer perpendicular to the layer thickness direction, the number-based cumulative distribution rate of the perovskite compound grains with a long diameter D of less than or equal to 1.0 µm is ≤ 8%. According to the embodiment of the present application, the number-based cumulative distribution rate of the perovskite compound grains with a long diameter D of 1.0 µm to 2.5 µm within the above range indicates that the percentage of the perovskite compound grains with the above grain size in the entire cross section is within a suitable range, and the percentage of the grains with a smaller size is relatively small, thereby improving the uniformity of the grain size of the entire light absorption layer. During the power generation process of the solar cell, the uniformity of the grain sizes is beneficial to the stability of the operation of the solar cells.

In any embodiment of the present application, in at least one cross section of the light absorption layer perpendicular to the layer thickness direction, the perovskite compound grains with a long diameter D of 1 µm to 6 µm are polygonal. The contact between the grains of the above shape is good and the porosity is small, which facilitates the improvement of the carrier transport efficiency and reduce the defects between the grains. This facilitates the stability and energy conversion efficiency of the operation of the solar cell, during the power generation process of the solar cell.

In any embodiment of the present application, in at least one cross section of the light absorption layer perpendicular to the layer thickness direction, the perovskite compound grains with a long diameter D of 1 µm to 4 µm are N-gonal, where N is a positive integer and N is more than 5, optionally 6-9. According to the embodiment of the present application, the polygonal perovskite compound grains are closely packed to each other, which is beneficial to improving the carrier transport efficiency and reducing the influence of grain boundary defects. This facilitates the stability and energy conversion efficiency of the operation of the solar cell, during the power generation process of the solar cell.

In any embodiment of the present application, the light absorption layer includes perovskite compound grains throughout the light absorption layer in at least one cross section in the layer thickness direction. The perovskite compound grains throughout the light absorption layer can be in direct contact with the first carrier transport sublayer and the second carrier transport sublayer, which can reduce the interface defects between the light absorption layer and the first carrier transport sublayer and the second carrier transport sublayer, respectively, reduce the non-radiative recombination losses between interfaces, reduce or avoid current transmission limitations, and improve the current intensity and energy conversion efficiency of the cell.

In any embodiment of the present application, the ratio of the perovskite compound grains throughout the light absorption layer to the total number of the grains in the light absorption layer is 50% to 90%, optionally 60% to 85%. The ratio of the perovskite compound grains throughout the light absorption layer to the total number of the grains in the light absorption layer is within the above range, which can further reduce the interface defects between the light absorption layer and the first carrier transport sublayer and the second carrier transport sublayer, respectively, reduce the non-radiative recombination losses between interfaces, reduce or avoid current transmission limitations, and improve the current intensity and energy conversion efficiency of the battery.

In any embodiment of the present application, the perovskite compound grains include primary grains and secondary grains, and the number of secondary grains account for 80%-100% of the total number of the perovskite compound grains, optionally 65%-95%.

In any embodiment of the present application, the solar cell includes a first carrier transport sublayer and a second carrier transport sublayer, and the solar cell includes:
a passivation layer between the light absorption layer and the first carrier transport sublayer and/or a passivation layer between the light absorption layer and the second carrier transport sublayer, where the passivation layer is used to reduce defects resulting from the contact of the two interfaces. The above-mentioned passivation layer is beneficial to the ohmic transmission of carriers, reduces the interface charge transport barrier caused by the poor interface contact resulting from the polarity difference between the light absorption layer and the carrier transport sublayer, reduces the defect density, optimizes the energy level, promotes internal charge transfer, and is beneficial to improving the energy conversion efficiency of the perovskite solar cell.

In a second aspect, an embodiment of the present application provides a method for preparing a solar cell, the method including:
preparing a light absorption layer including a plurality of perovskite compound grains as described in the first aspect by a non-contact closed annealing container, where in at least one cross section of the light absorption layer perpendicular to a layer thickness direction, and a number-based cumulative distribution rate of perovskite compound grains with a long diameter D of 1 µm to 6 µm is ≥ 90%.

According to the embodiment of the present application, the above-mentioned light absorption layer prepared by the non-contact closed annealing container increases the crystal quality of the perovskite compound grains in the light absorption layer, including the overall grain size, and can obtain the properties, such as an efficient light capture capacity, an ultrafast carrier transport capacity and ion migration inhibition. During the power generation process of solar cells, the overall grain size of the perovskite compound grains is larger, which reduces the number of grain boundaries between the perovskite compound grains, reduces or avoids the interference of interface defects, and promotes the charge separation at the interface, thereby improving the comprehensive performance of solar cells, including an energy conversion efficiency.

In any embodiment of the present application, the method includes at least one of the following conditions:
1) the closed annealing container includes an annealing atmosphere, and the annealing atmosphere includes a polar aprotic solvent; optionally, the polar aprotic solvent includes at least one of N,N-dimethylformamide, 1-methyl-2-pyrrolidone, dimethyl sulfoxide, and dimethylacetamide;
2) an annealing temperature in the closed annealing container is 100-180°C, optionally 120-160°C; and
3) an annealing time in the closed annealing container is 8-30 min, optionally 10-20 min.

According to the embodiments of the present application, by regulating the annealing atmosphere, annealing temperature and annealing time in the closed annealing container, the crystal quality of the perovskite compound grains including the overall grain size is comprehensively controlled, thereby improving the comprehensive performance of the solar cell including the energy conversion efficiency.

In a third aspect, an embodiment of the present application provides a solar cell module, including the solar cell of the second aspect.

In a fourth aspect, an embodiment of the present application provides an electrical device, including a solar cell module in any one of the embodiments of the third aspect of the present application, where the solar cell module is configured to provide electric energy.

The above description is only an overview of the technical solutions of the present application. To more clearly understand the technical means of the present application to implement same according to the contents of the description, and to make the above and other objectives, features, and advantages of the present application more obvious and understandable, specific implementations of the present application are exemplarily described below.

### BRIEF DESCRIPTION OF THE DRAWINGS

Various other advantages and benefits will become apparent to those of ordinary skill in the art upon reading the following detailed description of the preferred implementations. The accompanying drawings are merely used for illustrating the preferred implementations and are not intended to constitute a limitation on the present application. Moreover, like components are denoted by like reference signs throughout the accompanying drawings.

In the accompanying drawings:
FIG. 1 shows a schematic diagram of the measurement of the long diameter, short diameter and height in a cross section of a light absorption layer in an embodiment of the present application;
FIG. 2 shows a schematic cross-sectional structural diagram of a solar cell provided in an embodiment of the present application;
FIG. 3 shows a schematic cross-sectional structural diagram of a solar cell provided in an embodiment of the present application;
FIG. 4 shows a microscopic image of the long diameter of perovskite compound grains in a light absorption layer of a solar cell as provided in an embodiment of the present application;
FIG. 5 shows a microscopic image of the long diameter of perovskite compound grains in a light absorption layer of a solar cell as provided in a further embodiment of the present application;
FIG. 6 shows a microscopic image of the long diameter of perovskite compound grains in a light absorption layer of a solar cell as provided in a further embodiment of the present application; and
FIG. 7 shows a microscopic image of the height of perovskite compound grains in a light absorption layer of a solar cell as provided in an embodiment of the present application.

The drawings in the present application are not necessarily drawn to scale.

### DETAILED DESCRIPTION

The embodiments of the technical solution of the present application will be described in detail below with reference to the accompanying drawings. The following embodiments are only used to illustrate the technical solutions of the present application more explicitly, and are thus only interpreted as examples, rather than used to limit the protection scope of the present application.

Unless otherwise defined, all technical and scientific terms used herein have the same meanings as those commonly understood by those skilled in the art to which the present application belongs. The terms used herein are merely for the purpose of describing specific embodiments, but are not intended to limit the present application. The terms "include/comprise" and "has/have" and any variations thereof in the description and the claims of the present application as well as the brief description of the accompanying drawings described above are intended to cover non-exclusive inclusion.

In the description of the embodiments of the present application, the technical terms "first", "second", etc. are merely used for distinguishing different objects, and are not to be construed as indicating or implying relative importance or implicitly indicating the number, particular order or primary-secondary relationship of the indicated technical features. In the description according to the embodiments of the present application, "a plurality of" means two or more, unless otherwise expressly and specifically defined.

Embodiment mentioned in the specification means that particular features, structures, or characteristics described with reference to the embodiment may be included in at least one embodiment of the present application. The phrase at various locations in the description does not necessarily refer to the same embodiment, or an independent or alternative embodiment exclusive of another embodiment. A person skilled in the art explicitly or implicitly understands that the embodiments described in the specification may be combined with other embodiments.

In the description of the embodiments of the present application, the term "and/or" is merely intended to describe the associated relationship of associated objects, indicating that three relationships can exist. For example, A and/or B may include: only A exists, both A and B exist, and only B exists. In addition, the character "/" in this specification generally indicates an "or" relationship between the associated objects.

In the description of the embodiments of the present application, the term "a plurality of" means two or more (including two). Similarly, "a plurality of groups" means two or more groups (including two groups), and "a plurality of pieces" means two or more pieces (including two pieces).

In the description of the embodiments of the present application, the orientations or positional relationships indicated by the technical terms "central", "longitudinal", "transverse", "length", "width", "thickness", "upper", "lower", "front", "rear", "left", "right", "vertical", "horizontal", "top", "bottom", "inner", "outer", "clockwise", "counterclockwise", "axial", "radial", "circumferential", etc. are based on the orientations or positional relationships shown in the accompanying drawings and are merely intended to facilitate and simplify the description of the embodiments of the present application, rather than indicating or implying that the device or element referred to must have a particular orientation or be constructed and operated in a particular orientation, and therefore cannot be construed as limiting the embodiments of the present application.

In the description of the embodiments of the present application, unless otherwise explicitly specified and defined, the technical terms such as "mounting", "connecting", "connection" and "fixing" should be understood in a broad sense, for example, they may be a fixed connection, a detachable connection, or an integrated connection; may be a mechanical connection or an electric connection; or the connection may be a direct connection, an indirect connection through an intermediate medium, internal communication between two components, or an interaction relationship between two components. For those of ordinary skill in the art, the specific meanings of the above terms in the present application may be interpreted according to specific situations.

A solar cell is a device that directly converts light energy into electric energy by means of photoelectric effect or photochemical reaction. Examples of the solar cells include perovskite-type solar cells (perovskite solar cell) which are solar cells using a perovskite compound semiconductor as a light absorption material, and belong to the third generation of solar cells.

The perovskite compound in the perovskite solar cell will absorb photons of a certain energy, causing the electrons in the valence band to be excited and transferred to the conduction band, while leaving holes in the valence band to form bound electron-hole pairs. Such electron-hole pairs can be separated into free carriers and can be transmitted to the corresponding electrodes respectively to achieve photoelectric conversion. The crystal quality of the perovskite compound directly affects the initial efficiency and stability of the perovskite solar cell, but the crystal quality is greatly affected by the annealing process. During the process of engineering mass production of perovskite solar cells, how to ensure the annealing temperature regarding the consistency of the perovskite compound and the uniformity of the heated area are key issues in ensuring the crystal quality.

Currently, the annealing process widely used is mainly contact hot plate annealing. The annealing mechanism is mainly heat conduction or heat radiation, that is, the surface of the hot plate is heated by an electric heating wire, and then the heat is transferred to the substrate material of the perovskite solar cell (mainly a glass substrate or a flexible substrate) through the hot plate surface, and finally the heat is conducted upward to the perovskite. This procedure causes the following questions: first, the problem of uniform heating over a large area of the perovskite layer. Traditional annealing is mainly based on hot plate annealing. The uniformity of heating of the perovskite is restricted in many factors. One is the uniformity of the hot plate. The larger the heating area, the more difficult it is to control the temperature between different areas. The other difficult-to-control factor is that the substrate material of the perovskite solar cell, especially a glass, deforms during the heating, which directly leads to large differences in the heating rates of different areas of the perovskite layer. Due to uneven heating and large temperature differences in organisms, the perovskite compound grains are often of different sizes and uneven size distribution, which further leads to grain boundary defects. When a solar cell including perovskite compound grains of such different sizes and uneven size distribution is used, the carrier transport is affected, creating water more grain boundary defects, and reducing the energy conversion efficiency of the solar cell. Second, the perovskite grains prepared by the above annealing process are relatively small (generally less than 500nm). Smaller perovskite crystals will inevitably result in a larger number of grain boundaries. There are often unavoidable defects at the grain boundaries, which directly cause the open circuit voltage of the perovskite solar cell to drop, and the energy conversion efficiency to reduce, thus seriously affecting the performance of the perovskite solar cell.

In the related technology, a fluctuating thermal annealing process is used to strictly control the annealing temperature and annealing cycle of the perovskite photoactive layer. The crystal growth time is controlled by a short heating process, such that the grains of the perovskite active layer grow relatively orderly. During the slow growth stage, the perovskite grains can self-assemble, enabling the denser and more uniform contact between the grains. However, this solves the problem of large size differences or uniformity in perovskite grains. Based on the traditional contact hot plate annealing preparation, the resulting perovskite grains are relatively small (generally less than 500nm), and a large number of grain boundaries will be produced, which will inevitably bring many defects, resulting in a low efficiency and poor stability of the perovskite solar cells.

In view of the foregoing, a technical solution of an embodiment of the present application provides a solar cell which is capable of at least alleviating the adverse effects of the perovskite compound grains in the power generation process of the solar cell resulting from a larger number of grain boundaries and a larger number of defects of the grain boundaries due to the size of the grains, so as to improve the energy conversion efficiency of the solar cell.

### Solar Cell

In a first aspect, an embodiment of the present application provides a solar cell, including a light absorption layer.

The light absorption layer includes a plurality of perovskite compound grains. In at least one cross section of the light absorption layer perpendicular to a layer thickness direction, and a number-based cumulative distribution rate of the perovskite compound grains with a long diameter D of 1 µm to 6 µm is ≥ 90%.

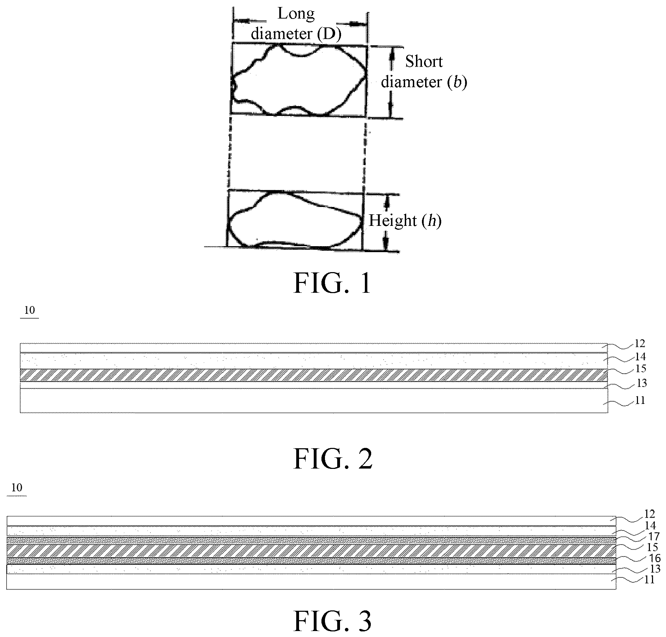

According to an embodiment of the present application, the long diameter D of the perovskite compound grains is measured on a cross section of the light absorption layer perpendicular to the layer thickness direction, and optionally the short diameter b of the perovskite compound grains can be measured. The thickness h of the perovskite compound grains can be measured in a cross section of the light absorption layer in the layer thickness direction, and thus the long diameter D reflects the actual long diameter of the perovskite compound grains. The long diameter can be understood as the longest grain size measured in the perovskite compound grains. As shown in FIG. 1.

According to the embodiment of the present application, a number-based cumulative distribution rate of the perovskite compound grains represents the percentage of the perovskite compound grains with a specific grain size in the number of all perovskite compound grains in the cross section. The percentage content is calculated based on the number. A number-based cumulative distribution rate of the perovskite compound grains = the number of perovskite grains within a size range in the corresponding SEM image/the number of all the perovskite grains in the corresponding SEM image × 100%.

According to the technical solution of the embodiment of the present application, the crystal defects of the perovskite compound grains themselves in the light absorption layer of the solar cell will cause non-radiative recombination of carriers, thereby causing a certain amount of energy loss and reducing the photoelectric conversion efficiency of the solar cell. The number-based cumulative distribution rate of the perovskite compound grains with a long diameter D of 1 µm to 6 µm in the present application is within the above range, which increases the crystal quality of the perovskite compound grains in the light absorption layer, including the overall grain size, and can achieve the properties, such as an efficient light capture capacity, an ultrafast carrier transport capacity and ion migration inhibition. During the power generation process of solar cells, the overall grain size of the perovskite compound grains is larger, which reduces the number of grain boundaries between the perovskite compound grains, reduces or avoids the interference of interface defects, and promotes the charge separation at the interface, thereby improving the comprehensive performance of solar cells, including an energy conversion efficiency.

In addition, the open circuit voltage is affected by the minimum energy required to excite electrons and the energy gap of the semiconductor material itself. If the energy gap is relatively large, the open circuit voltage will increase, and the number of photons required will also decrease. During the power generation process of solar cells, the larger grain size of perovskite compound grains is conducive to having a suitable energy gap, improving light capture capacity, and reducing the number of photons required, which is beneficial to increasing the open circuit voltage.

Optionally, the long diameter D of the perovskite compound grains can be any value of 1.0 µm, 1.5 µm, 2.0 µm, 2.5 µm, 3.0 µm, 3.5 µm, 4.0 µm, 4.5 µm, 4.6 µm, 4.7 µm, 4.8 µm, 4.9 µm, 5.0 µm, 5.1 µm, 5.2 µm, 5.3 µm, 5.4 µm, 5.5 µm, 5.6 µm, 5.7 µm, 5.8 µm, 5.9 µm, 6.0 µm or a range composed of these values. The number-based cumulative distribution rate of the perovskite compound grains with a long diameter D of 1 µm to 6 µm can be any value of 90%, 91%, 92%, 93%, 94%, 95%, 96%, 97% or a range composed of these values. The long diameter D of the perovskite compound grains is within the above range, which further increases the overall grain size of the perovskite compound grains in the light absorption layer. When the number-based cumulative distribution rate of the perovskite compound grains with a long diameter D of 1 µm to 6 microns is within the above range, during the power generation process of the solar cells, the overall grain size of the perovskite compound grains is larger, which further reduces the number of the grain boundaries between the perovskite compound grains, reduces or avoids the interference of interface defects, and improves the energy conversion efficiency.

In some embodiments, at least one cross section of the light absorption layer perpendicular to the thickness direction of the layer may be a cross section in the thickness direction of the light absorption layer and close to the surface layer thereof. Optionally, the above cross section may be a cross section of an end face in the thickness direction of the light absorption layer. The thickness of the surface layer ranges from ≤ 100 nm, optionally ≤ 50 nm.

In some optional embodiments of the present application, in at least one cross section of the light absorption layer perpendicular to the layer thickness direction, the number-based cumulative distribution rate of the perovskite compound grains with a long diameter D of 2.0 µm to 5.0 µm is ≥ 75%. Optionally, the number-based cumulative distribution rate of the perovskite compound grains with a long diameter D of 2.0 µm to 5.0 µm can be any value of 75%, 76%, 77%, 78%, 79%, 80%, 85%, 90%, 95%, or a range composed of these values. The number-based cumulative distribution rate of the perovskite compound grains with a long diameter D of 2.0 µm to 5.0 µm is within the above range, thereby increasing the overall grain size of the perovskite compound grains; the long diameter D is 2.0 µm to 5.0 µm, which improves the uniformity of the grain size of the perovskite compound. During the power generation process of the solar cells, the number of the grain boundaries between perovskite compound grains are reduced, the interference of interface defects is reduced or avoided, and the energy conversion efficiency is improved.

The perovskite compound grains with a long diameter D of 2.0 µm to 5.0 µm have a suitable energy gap. When the number-based cumulative distribution rate of perovskite compound grains is within the above range, the light capture capacity can be improved and the open circuit voltage of the solar cell can be increased.

In some optional embodiments of the present application, in at least one cross section of the light absorption layer perpendicular to the layer thickness direction, the number-based cumulative distribution rate of the perovskite compound grains with a long diameter D of 2.0 µm to 3.5 µm is ≥ 50%. Optionally, the number-based cumulative distribution rate of the perovskite compound grains with a long diameter D of 2.0 µm to 3.5 µm can be any value of 50%, 51%, 52%, 53%, 54%, 55%, 56%, 57%, 58%, 59%, 60%, 65%, 70%, 75%, 80%, 90%, 95% or a range composed of these values.

According to the embodiment of the present application, the number-based cumulative distribution rate of the perovskite compound grains with a long diameter D of 2.0 µm to 3.5 µm is within the above range, which improves the uniformity of the grain sizes and the overall grain size of the perovskite compound. During the power generation process of the solar cells, the number of the grain boundaries between perovskite compound grains are reduced, the interference of interface defects is reduced or avoided, and the energy conversion efficiency is improved.

In some optional embodiments of the present application, in at least one cross section of the light absorption layer perpendicular to the layer thickness direction, the number-based cumulative distribution rate of the perovskite compound grains with a long diameter D of more than or equal to 3.5 µm is 5%-30%. Optionally, the number-based cumulative distribution rate of the perovskite compound grains with a long diameter D of more than or equal to 3.5 µm can be any value of 5%, 6%, 7%, 8%, 9%, 10%, 15%, 20%, 25%, 26%, 27%, 28%, 29%, 30%, or a range composed of these values. According to the embodiment of the present application, the number-based cumulative distribution rate of the perovskite compound grains with a long diameter D of more than or equal 3.5 µm within the above range indicates that the percentage of the perovskite compound grains with the above grain size in the entire cross section is within a suitable range, and the percentage of the grains with a larger size is relatively small, thereby improving the uniformity of the grain size of the entire light absorption layer. During the power generation process of the solar cell, the uniformity of the grain sizes is beneficial to the stability of the operation of the solar cells.

In some optional embodiments of the present application, in at least one cross section of the light absorption layer perpendicular to the layer thickness direction, the number-based cumulative distribution rate of the perovskite compound grains with a long diameter D of 2.5 µm to 3.0 µm is ≥ 60%. Optionally, the number-based cumulative distribution rate of the perovskite compound grains with a long diameter D of 2.5 µm to 3.0 µm can be any value of 60%, 61%, 62%, 63%, 64%, 65%, 70%, 75%, 80%, 81%, 82%, 83%, 84%, 90%, 95% or a range composed of these values. According to the embodiment of the present application, the number-based cumulative distribution rate of the perovskite compound grains with a long diameter D of 2.5 µm to 3.0 µm is within the above range, which improves the uniformity of the grain sizes and the overall grain size of the perovskite compound. During the power generation process of the solar cells, the number of the grain boundaries between perovskite compound grains are reduced, the interference of interface defects is reduced or avoided, and the energy conversion efficiency is improved.

In some optional embodiments of the present application, in at least one cross section of the light absorption layer perpendicular to the layer thickness direction, the number-based cumulative distribution rate of the perovskite compound grains with a long diameter D of 1.0 µm to 2.5 µm is 20%-40%. The number-based cumulative distribution rate of the perovskite compound grains with a long diameter D of 1.0 µm to 2.5 µm can be any value of 20%, 21%, 22%, 23%, 24%, 25%, 26%, 27%, 28%, 29%, 30%, 32%, 35%, 36%, 37%, 38%, 39%, and 40%, or a range composed of these values. According to the embodiment of the present application, the number-based cumulative distribution rate of the perovskite compound grains with a long diameter D of 1.0 µm to 2.5 µm within the above range indicates that the percentage of the perovskite compound grains with the above grain size in the entire cross section is within a suitable range, and the percentage of the grains with a smaller size is relatively small, thereby improving the uniformity of the grain size of the entire light absorption layer. During the power generation process of the solar cell, the uniformity of the grain sizes is beneficial to the stability of the operation of the solar cells.

In some optional embodiments of the present application, in at least one cross section of the light absorption layer perpendicular to the layer thickness direction, the number-based cumulative distribution rate of the perovskite compound grains with a long diameter D of less than or equal to 1.0 µm is ≤ 8%. The number-based cumulative distribution rate of the perovskite compound grains with a long diameter D of less than or equal to 1.0 µm can be any value of 1%, 2%, 3%, 4%, 5%, 6%, 7%, 8%, or a range composed of these values. According to the embodiment of the present application, the number-based cumulative distribution rate of the perovskite compound grains with a long diameter D of less than or equal 1.0 µm within the above range indicates that the percentage of the perovskite compound grains with the above grain size in the entire cross section is within a suitable range, and the percentage of the grains with a smaller size is relatively small, thereby improving the uniformity of the grain size of the entire light absorption layer. During the power generation process of the solar cell, the uniformity of the grain sizes is beneficial to the stability of the operation of the solar cells.

In some optional embodiments of the present application, in at least one cross section of the light absorption layer perpendicular to the layer thickness direction, the perovskite compound grains with a long diameter D of 1 µm to 6 µm are polygonal.

According to the embodiments of the present application, the porosity or defects in adhesion between the perovskite compound grains in the light absorption layer of the solar cell may cause non-radiative recombination of carriers, thereby causing a certain amount of energy loss and reducing the photoelectric conversion efficiency of the solar cell. The contact between the grains of the above shape is good and the porosity is small, which facilitates the improvement of the carrier transport efficiency and reduce the defects between the grains. This facilitates the stability and energy conversion efficiency of the operation of the solar cell, during the power generation process of the solar cell.

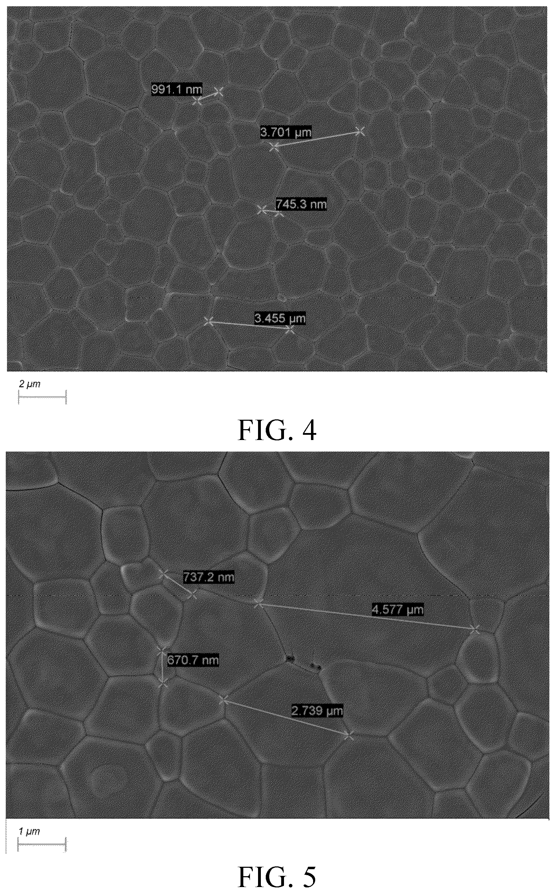

As an example, the perovskite compound grains with a long diameter D of 1 µm to 6 µm are polygonal as shown in FIGS. 4-6.

In some optional embodiments of the present application, in at least one cross section of the light absorption layer perpendicular to the layer thickness direction, the perovskite compound grains with a long diameter D of 1 µm to 4 µm are N-gonal, where N is a positive integer and N is more than 5, optionally 6-9.

According to the embodiment of the present application, the polygonal perovskite compound grains are closely packed to each other, which is beneficial to improving the carrier transport efficiency and reducing the influence of grain boundary defects. This facilitates the stability and energy conversion efficiency of the operation of the solar cell, during the power generation process of the solar cell.

In some optional embodiments of the present application, the light absorption layer includes perovskite compound grains throughout the light absorption layer in at least one cross section in the layer thickness direction.

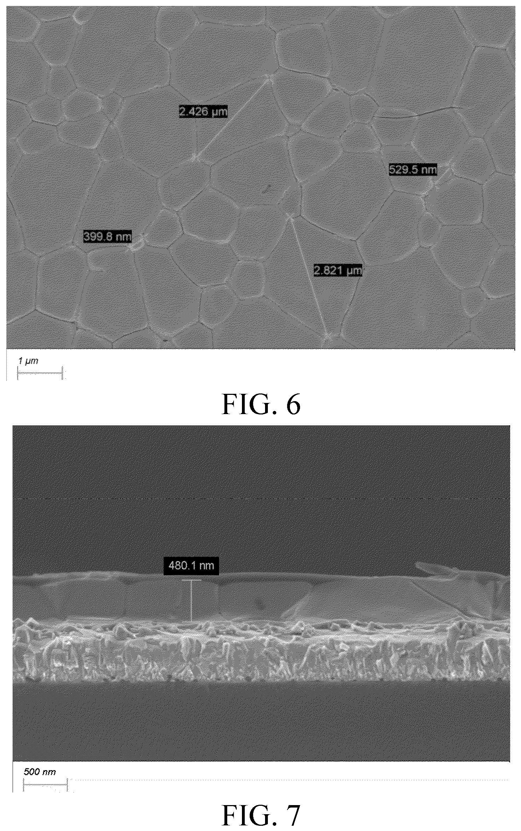

In the embodiment of the present application, the perovskite compound grains throughout the light absorption layer can be measured from a cross section parallel to the thickness direction of the light absorption layer, that is, the height h of the perovskite compound grains is measured, as shown in FIG. 1. As an example, perovskite compound grains throughout the light absorption layer are shown in FIG. 7.

The carriers formed by the light excitation of the perovskite compounds in the solar cell diffuse in the light absorption layer. When they reach the interface between the electron transport layer/hole transport layer and the light absorption layer, if the energy levels of the two functional layers match each other, free electrons and holes are formed under the action of the interface potential barrier. Defects inside perovskite compounds and at the interface between the two transport layers will cause non-radiative recombination of carriers, resulting in a certain amount of energy loss and reducing the photoelectric conversion efficiency of the perovskite solar cells. Therefore, the perovskite compound grains throughout the light absorption layer can be in direct contact with the first carrier transport sublayer and the second carrier transport sublayer, which can reduce the interface defects between the light absorption layer and the first carrier transport sublayer and the second carrier transport sublayer, respectively, reduce the non-radiative recombination losses between interfaces, reduce or avoid current transmission limitations, and improve the current intensity and energy conversion efficiency of the battery.

In some optional embodiments of the present application, the ratio of the perovskite compound grains throughout the light absorption layer to the total number of the grains in the light absorption layer is 50% to 90%, optionally 60% to 85%. The ratio of the perovskite compound grains throughout the light absorption layer to the total number of the grains in the light absorption layer is within the above range, which further reduces the interface defects between the light absorption layer and the first carrier transport sublayer and the second carrier transport sublayer, respectively, further reduces or avoids current transmission limitations, and improves the current intensity and energy conversion efficiency of the battery.

In some optional embodiments of the present application, the perovskite compound grains include primary grains and secondary grains, and the number of secondary grains account for 80%-100% of the total number of the perovskite compound grains, optionally 65%-95%.

According to the embodiment of the present application, the primary grains refer to the dense, fine and uniform grains obtained in the initial stage of annealing of the perovskite compound. Secondary grains refer to grown grains from primary grains, where the primary grains continue to anneal in a trace solvent atmosphere, and according to the Ostwald ripening effect, small grains are continuously dissolved to form a solute atmosphere and is absorbed by slightly larger grains due to chemical kinetics, gradually forming a large grain structure, that is, the large grains with small surface energy merger the small grains with large surface energy. Generally speaking, the long diameter of a primary grain ranges from about 100 nm to 800 nm, and the volume of a secondary grain can reach 1 µm to 6 µm.

In some optional embodiments of the present application, the perovskite compound grains include an organic-inorganic perovskite compound of general formula ABX3, where A is an organic cation, B is a metal cation, and X is a halogen anion or SCN⁻. In some embodiments of the present application, the halogen X includes at least one of chlorine, bromine and iodine.

It may be understood that: perovskite materials with different halogen ions have different forbidden band gaps. The band gap of perovskite materials with halogen ions I- is the smallest (generally around 1.5 electron volts), and the band gap of perovskite materials with halogen ions Cl-is the largest (generally around 3 electron volts). Moreover, the perovskite material can contain two mixed halogen ions, at a mixing ratio that can be continuously adjusted. Therefore, the band gap of the perovskite material can be continuously adjusted within the range of 1.5-3 electron volts, corresponding to the wavelength range of the absorbable light of about 414-820 nm, which essentially covers the entire visible light spectrum. Carriers are generated in the light absorption layer.

For example: in ABX₃ A can include at least one of CH₃NH³⁺ and HC(NH₂)²⁺. In other words, A can be CH₃NH³⁺, HC(NH₂)²⁺ or a mixture of the two in any ratio. It may be understood that A may also include metal ions, such as least one of Cs⁺, Rb⁺ and K⁺.

For example: in ABX₃, B can be at least one of Pb²⁺, Sn²⁺ and Ge²⁺.

For example, ABX₃ can be CH₃NH₃PbI₃; CH₃NH₃SnI₃; CH₃NH₃PbI₂ Cl; CH₃NH₃ PbI₂Br; CH₃NH₃Pb(I₁₋ₓBrₓ)₃ (where 0 < x < 1), etc.

In some embodiments, the organic cation A includes at least one of an ammonium and an ammonium derivative. In some examples, the ammonium may be an alkylammonium.

In some embodiments, the ammonium includes at least one of methylammonium, ethylammonium, propylammonium, butylammonium, pentylammonium, hexylammonium, and formamidinium. The ammonium derivative may include imidazolium.

In some embodiments, the metal in the metal cation B includes at least one of lead (Pb), cesium (Cs), tin (Sn), zinc (Zn), titanium (Ti), antimony (Sb), bismuth (Bi), nickel (Ni), iron (Fe), cobalt (Co), silver (Ag), copper (Cu), gallium (Ga), germanium (Ge), magnesium (Mg), calcium (Ca), indium (In), aluminum (Al), manganese (Mn), chromium (Cr), molybdenum (Mo), and europium (Eu). B in general formula ABX3 is selected from the above-mentioned metal cations, which can facilitate the improvement of the photoelectric conversion efficiency of the light absorption layer.

FIG. 2 shows a schematic cross-sectional structural diagram of a solar cell according to an embodiment of the present application. As shown in FIG. 2, the solar cell 10 includes the following structures stacked in sequence: a first electrode layer 11; a first carrier transport sublayer 13; a light absorption layer 15; a second carrier transport sublayer 14; and a second electrode layer 12.

In some embodiments of the present application, the first electrode layer 11 may be made of a conductor, where the conductor has a high work function to facilitate the injection of holes. Exemplarily, the conductor may be a metal, a metal oxide and/or a conductive polymer.

Exemplarily, the first electrode layer 11 may be made of a metal. For example, the material of the first electrode 11 includes at least one of nickel (Ni), platinum (Pt), vanadium (V), chromium (Cr), copper (Cu), zinc (Zn), gold (Au), silver (Ag) or an alloy thereof. The first electrode 131 may also be made of a metal oxide. For example, the material of the first electrode 131 includes at least one of zinc oxide (ZnO), indium oxide (In2O3), fluorine-doped tin oxide (FTO), indium tin oxide (ITO), nickel oxide (NiO), aluminum zinc oxide (AZO), indium zinc oxide (IZO) and gallium zinc oxide (GZO). The first electrode 131 may also be made of a conductive polymer. For example, the material of the first electrode 131 includes at least one of poly(3-methylthiophene), poly(3,4-(ethylene-1,2-dioxy)thiophene) (PEDOT), polypyrrole and polyaniline.

In an embodiment of the present application, the second electrode layer 12 may also be made of a conductor, where the conductor has a lower work function to facilitate the injection of electrons. Exemplarily, the material of the second electrode 12 includes at least one of copper (Cu), magnesium (Mg), aluminum (Al), nickel (Ni), silver (Ag), tin (Sn), chromium (Cr), bismuth (Bi), platinum (Pt), molybdenum (Mo), tungsten (W) or an alloy thereof, carbon (C), graphene, carbon nanotubes, fluorine-doped tin oxide (FTO), indium tin oxide (ITO), aluminum zinc oxide (AZO), indium zinc oxide (IZO) and gallium zinc oxide (GZO).

In some embodiments, the solar cell includes a first carrier transport sublayer 13 and a second carrier transport sublayer 14 disposed respectively on either side of the light absorption layer 15. The first carrier transport sublayer 13 and the second carrier transport sublayer 14 are disposed in an interdependence.

The first carrier transport sublayer 13 and the second carrier transport sublayer 14 have opposite carrier selectivity. If the first carrier transport sublayer 13 has electron selectivity and the second carrier transport sublayer 14 has hole selectivity, then after the light absorption layer 15 absorbs sunlight and generates carriers, the electrons in the carriers are selected by the first carrier transport sublayer 13 and transported to the first electrode layer 11, and then collected by the first electrode layer 11, and the holes after losing the electrons are selected by the second carrier transport sublayer 15 which transmits the electrical properties thereof to the second electrode layer 12, and then collected by the second electrode layer 12, thereby achieving separation of charge carriers in the perovskite compound in the light absorption layer 15.

If the first carrier transport sublayer 13 has hole selectivity and the second carrier transport sublayer 14 has electron selectivity, then after the light absorption layer 15 absorbs sunlight and generates carriers, the holes that lose electrons are selected by the first carrier transport sublayer 13 which transmits the electrical properties thereof to the first electrode layer 11, and then collected by the first electrode layer 11, and the electrons in the carriers are selected by the second carrier transport sublayer 30 and transported to the second electrode layer 12, and then collected by the second electrode layer 12, thereby realizing the separation of carriers in the light absorption layer 15.

Further, the first carrier transport sublayer 13 is disposed on the light-facing side of the light absorption layer 15, and the second carrier transport sublayer 14 is disposed on the backlight side of the light absorption layer 15, and the first carrier transport sublayer 13 and the second carrier transport sublayer

15 correspond to opposite carrier selectivities. The first electrode layer 11 is provided on a side of the first carrier transport sublayer 13 away from the light absorption layer 15, and the second electrode layer 12 is provided on a side of the second carrier transport sublayer 14 away from the light absorption layer 15, and the second electrode layer 12 and the second carrier transport sublayer 14 are electrically connected.

According to an embodiment of the present application, the first carrier transport sublayer 13 and the second carrier transport sublayer 14 each may be a single-layer structure or a multi-layer structure.

In some embodiments of the present application, the materials having hole selectivity include at least one of thiophene, phthalocyanine, porphyrin, 2,2',7,7'-tetrakis(N,N-di-p-methoxyaniline)-9,9'-spirobifluorene, molybdenum oxide (MoO₃), vanadium oxide (V₂O₅), tungsten oxide (WO₃ and/or WO₂), nickel oxide (NiO), copper oxide (CuO), tin oxide (SnO₂), molybdenum sulphide (MoS₂), tungsten sulphide (WS₂), copper sulphide (CuS), tin sulphide (SnS), cuprous thiocyanate (CuSCN), copper iodide (CuI), a fluorine-containing phosphonic acid, a carbonyl-containing phosphonic acid, carbon nanotubes, and graphene.

In some embodiments of the present application, the material having electron selectivity includes at least one of methyl [6,6]-phenyl-C61-isobutyrate, C60, cyano-containing polyphenylacetylene, a boron-containing polymer, bathocuproin, bathophenanthroline, hydroxyquinoline aluminum, an oxadiazole compound, a benzimidazole compound, a naphthalene tetracarboxylic acid compound, a perylene derivative, a phosphine oxide compound, a phosphorus sulfide compound, a fluorine-containing phthalocyanine, titanium oxide (TiO₂), zinc oxide(ZnO), tin oxide (SnO₂), indium oxide (In₂O₃), gallium oxide (Ga₂O₃), tin sulfide (SnS), indium sulfide (In₂O₃), lithium fluoride (LiF), sodium fluoride (NaF), magnesium fluoride (MgF₂) and zinc sulfide (ZnS).

In some optional embodiments of the present application, the solar cell includes a first carrier transport sublayer and a second carrier transport sublayer, and the solar cell includes:
a passivation layer between the light absorption layer and the first carrier transport sublayer and/or a passivation layer between the light absorption layer and the second carrier transport sublayer. The passivation layer is used to reduce defects resulting from the contact of the two interfaces.

FIG. 3 shows a schematic cross-sectional structural diagram of a solar cell according to an embodiment of the present application. As shown in FIG. 3, the solar cell 10 includes the following structures stacked in sequence: a first electrode layer 11; a first carrier transport sublayer 13; a first passivation layer 16; a light absorption layer 15; a second passivation layer 17; a second carrier transport sublayer 14; and a second electrode layer 12.

According to an embodiment of the present application, the material of the passivation layer may be those commonly used in the art. As an example, the material may include methyl-substituted carbazole molecules (Me-4PACz). The methyl-substituted carbazole molecules (Me-4PACz) can be understood as a self-assembled molecular layer. The thickness can be 1-5 nm.

The light absorption layer in the solar cell absorbs energy and releases carriers that diffuse in the perovskite. When they reach the interface between the electron transport layer/hole transport layer and the light absorption layer, defects in the perovskite compounds and at the interface between the two transport layers will cause non-radiative recombination of carriers, resulting in a certain amount of energy loss and reducing the photoelectric conversion efficiency of the perovskite solar cells. The above-mentioned passivation layer is beneficial to the ohmic transmission of carriers, reduces the interface charge transport barrier caused by the poor interface contact resulting from the polarity difference between the light absorption layer and the carrier transport layer, reduces the defect density, optimizes the energy level, promotes internal charge transfer, and is beneficial to improving the energy conversion efficiency of the perovskite solar cell.

In some embodiments, the solar cell includes a substrate provided on a side of the first electrode layer facing away from the second electrode layer. The material of the substrate is a glass or a mixture of one or more of transparent organic polymers: the organic polymer includes one or more of PET (polyethylene terephthalate) and PI (polyimide).

### [Method for preparing solar cell]

In the embodiments of the present application, a solar cell 10 may be manufactured by a method known in the art.

In some embodiments of the present application, a method for preparing a solar cell includes:
S10: providing a first electrode layer;
S20: forming a first carrier transport sublayer on a side of the first electrode layer;
S30: forming a light absorption layer on a side of the first carrier transport sublayer away from the first electrode layer;
S40: forming a second carrier transport sublayer on a side of the light absorption layer away from the first carrier transport sublayer;
S50: forming a second electrode layer on a side of the second carrier transport sublayer away from the light absorption layer.

Exemplarily, a method for manufacturing a solar cell device 10 may include: a first carrier transport sublayer 13, a light absorption layer 15, a second carrier transport sublayer 14 and a second electrode layer 12 are sequentially formed on a transparent or opaque first electrode layer 11 from bottom to top. Herein, the light absorption layer 15 can be formed by any known film formation method such as evaporation, sputtering, spin coating, dipping, or ion plating.

The preparation process for the light absorption layer includes: three steps: wet film coating, solvent quenching and annealing.

The wet film coating includes: in a wet film coating state, the perovskite is in a colloidal state, and ABX₃ is distributed in a precursor solvent and coated on a substrate.

The solvent quenching includes: By quickly removing a large amount of organic solvent in the perovskite precursor solution, only a small amount of organic solvent is left to complex with the perovskite component. At this time, the perovskite is in an intermediate state, and the general formula is generally AX·BX₂·organic solvent. The above process is the process in which part of the solute forms crystal seeds.

The annealing includes: AX·BX₂·organic solvent will gradually lose solvent molecules to form a complete ABX₃. During the annealing process, the crystal seeds absorb solutes that are left with solvent molecules removed, thus growing into perovskite grains. Generally, since the solute content is given, the number of seeds is inversely proportional to the grain size.

In a second aspect, an embodiment of the present application provides a method for preparing a solar cell, the method including:
preparing a light absorption layer including a plurality of perovskite compound grains as described in the first aspect by using a non-contact closed annealing container, where in at least one cross section of the light absorption layer perpendicular to a layer thickness direction, and a number-based cumulative distribution rate of the perovskite compound grains with a long diameter D of 1 µm to 6 µm is ≥ 90%.

In the related art, contact hot plate annealing is an annealing process achieved by heat conduction. During the engineering preparation of a perovskite layer on a large scale, the temperature increases unevenly due to the warping of the glass, resulting in inconsistent growth rates of the seed crystals and different grain sizes. Furthermore, the seed crystals have a large number and are irreversible, resulting in generally small grains (the maximum grain width is less than 500 nm).

According to the embodiment of the present application, the above-mentioned light absorption layer prepared by the non-contact closed annealing container increases the crystal quality of the perovskite compound grains in the light absorption layer, including the overall grain size, and can obtain the properties, such as an efficient light capture capacity, an ultrafast carrier transport capacity and ion migration inhibition. During the power generation process of solar cells, the overall grain size of the perovskite compound grains is larger, which reduces the number of grain boundaries between the perovskite compound grains, reduces or avoids the interference of interface defects, and promotes the charge separation at the interface, thereby improving the comprehensive performance of solar cells, including an energy conversion efficiency.

In an embodiment of the present application, the leukemia non-contact closed annealing container performs annealing using a non-contact closed oven to achieve uniform temperature increase of the seed crystals, and the volatile organic solvent molecules will accumulate in the annealing atmosphere to form a specific solvent annealing atmosphere, which will gradually dissolve the small grains, and allows the large grains to absorb these dissolved small grains by means of the Oswald ripening effect, and gradually grow into larger perovskite compound grains, with a reduced number of grain boundaries and fewer defects. The Ostwald ripening effect is a phenomenon that can be observed in a solid solution or a liquid sol, which describes the changes that occur in a non-uniform structure over time: smaller crystals or sol particles in the solute dissolve and redeposit onto larger crystals or sol particles. By means of the reduction of specific interface energy per unit mass, and the reduction of the total free energy of the system, a reaction occurs spontaneously.

In any embodiment of the present application, the method includes at least one of the following conditions:
1) the closed annealing container includes an annealing atmosphere, and the annealing atmosphere includes a polar aprotic solvent; optionally, the polar aprotic solvent includes at least one of N,N-dimethylformamide, 1-methyl-2-pyrrolidone, dimethyl sulfoxide, and dimethylacetamide;
2) an annealing temperature in the closed annealing container is 100-180°C, optionally 120-160°C; and
3) an annealing time in the closed annealing container is 8-30 min, optionally 10-20 min.

According to the embodiments of the present application, by regulating the annealing atmosphere, annealing temperature and annealing time in the closed annealing container, the crystal quality of the perovskite compound grains including the overall grain size is comprehensively controlled, thereby improving the comprehensive performance of the solar cell including the energy conversion efficiency.

In some embodiments, the closed oven has a first heating source and a second heating source. In some embodiments, the first heating source and the second heating source may be disposed opposite each other, with an intervening space for accommodating a structure to be prepared. The structure to be prepared may be a first electrode layer, a first carrier layer and a mixture coated on the first carrier layer that are stacked, and the mixture is used to prepare a light absorption layer. The first heating source and the second heating source can heat the closed oven by themselves, and can also conduct the heat of the heat source. In some embodiments, the closed oven includes a carrier, which contacts the edge of the structure to be prepared, with the center region of the structure to be prepared being suspended. The position where the carrier contacts the structure to be prepared is ≤ 5 mm away from the edge of the structure to be prepared. In some embodiments, along the direction of the first heating source and the second heating source that are disposed opposite each other, the first heating substrate and the second heating substrate can have a cross section width of 5-100 mm, preferably 20-80 mm. In some embodiments, the surfaces of the first heating source and the second heating source are respectively 28-32 mm away from the surface of the structure to be prepared, optionally 30 mm.

### Solar cell module

The solar cell module provided in the embodiment of the present application may include a solar cell 10 according to the first aspect, or a plurality of solar cells according to the first aspect. If there are a plurality of solar cells, the plurality of solar cells can be connected in series connection or parallel connection or series-parallel connection with one another. The series-parallel connection means that some of the plurality of solar cells are in series connection and the rest are in parallel connection.

In some embodiments, the solar cell module includes a protective layer and/or an encapsulation layer.

### [Protective layer]

The protective layer is provided between the encapsulation layer and the solar cell, and the protective layer contains a metal halide and/or an organic halide. The metal halide and organic halide in the protective layer can absorb the ingress water and oxygen, reduce the corrosion of water and oxygen on the organic-inorganic perovskite compounds in the light absorption layer, and thus improve the stability of the solar cell, which facilitates prolonging the service life of the solar cell device.

In some optional embodiments of the present application, the metal halide has general formula BXk, where the value of k is in the range of 1-3. The organic halide has general formula AX.

In the above embodiments, the metal halide and the organic halide respectively have the above general formula, which enables the protective layer to absorb water and oxygen while generating substances similar to or identical to the precursor substances of the organic-inorganic perovskite compounds. These substances can react to form perovskite compounds with functions close to those of the organic-inorganic perovskite compounds, thereby allowing the solar cell to have a longer service life in the case of water and oxygen ingress.

In some optional embodiments of the present application, the organic cation in the organic-inorganic perovskite compound and the organic cation in the organic halide are the same or are homologues to each other.

In the present application, homologues refer to organic compounds with similar structures and molecular compositions that differ by several "CH2" atomic groups.

In the above embodiments, the organic cation in the general formula ABX3 and the organic cation in the general formula AX are the same or homologues to each other, which can facilitate the formation of an organic-inorganic perovskite compound from the organic halide in the protective layer 15 and the precursor material.

In some optional embodiments of the present application, the organic cation includes at least one of ammonium and an ammonium derivative, such as alkylammonium.

In some optional embodiments of the present application, the ammonium includes at least one of methylammonium, ethylammonium, propylammonium, butylammonium, pentylammonium, hexylammonium, and formamidinium. The ammonium derivative includes imidazolium.

Exemplarily, when the organic cation in the organic-inorganic perovskite compound is the same as the organic cation in the organic halide, the organic cation in the organic-inorganic perovskite compound is methylammonium (CH₃NH⁻), the organic cation in the organic halide is also methylammonium (CH₃NH⁻).

For example, when the organic cation in the general formula ABX₃ and the organic cation in the general formula AX are homologues of each other, the organic cation in the organic-inorganic perovskite compound is methylammonium (CH₃NH⁻), the organic cation in the organic halide can be ethylammonium (CH₃CH₂NH⁻), propylammonium (CH₃CH₂CH₂NH⁻).

In the embodiments of the present application, the protective layer may be a single-layer structure or a multi-layer structure, and the specific number of layers may be designed according to requirements.

In some optional embodiments of the present application, the protective layer includes at least one of an MOF material, activated carbon, montmorillonite, diatomaceous earth, zeolite, a molecular sieve, kaolin, an ion exchange resin and 2-methylimidazole zinc salt MAF-4 to provide a porous structure.

### [Encapsulation layer]

The encapsulation layer can encapsulate the solar cell between the cover plate and the substrate to protect the solar cell.

Some optional materials for the encapsulation layer in the present application include at least one of a thermoplastic encapsulation adhesive, a thermosetting encapsulation adhesive and a light-curable encapsulation adhesive.

Exemplarily, the thermoplastic encapsulation adhesive includes at least one of an ethylene-vinyl acetate copolymer, polyvinyl butyral, an ethylene-octene copolymer, polyisobutylene, a polyolefin encapsulation adhesive and a butyl rubber. The thermosetting encapsulation adhesive includes at least one of an epoxy encapsulation adhesive, a silicone encapsulation adhesive and a polyurethane encapsulation adhesive. The curable encapsulation adhesive includes at least one of an ultraviolet light curable encapsulation adhesive and an infrared light curable encapsulation adhesive.

### Electrical device

In a third aspect, an embodiment of the present application provides an electrical device, including the solar cell module of the second aspect, where the solar cell module is configured to provide electric energy.

Electrical devices can be used in, but not limited to, construction, military, travel, defense, power supply and other fields, such as: a mobile phone, a tablet, a notebook computer, an electric toy, an electric tool, a battery cart, an electric vehicle, a ship, a spacecraft, a photovoltaic greenhouse, a photovoltaic water heater, etc.

Content disclosed in the present application is described in detail in the following examples. These examples are only for illustrative purposes because various modifications and changes made without departing from the scope of the content disclosed in the present application are apparent to persons skilled in the art. Unless otherwise noted, all parts, percentages and ratios reported in the following examples are on a weight basis, and all reagents used in the examples are commercially available or are synthesized according to conventional methods, and can be used directly without further treatment, and the instruments used in the examples are commercially available.

### Embodiment 1

The present invention provided a method for manufacturing a solar cell module, which included the following steps:
(1) Formation of solar cell device: A group of FTO conductive glass with a specification of 30 cm × 30 cm was etched using infrared laser to form P1 having a width of about 30 um, and the whole piece of glass was divided into 44 sub-cells in sequence in the longer side direction. The series resistance of different sub-cells was greater than 10 MΩ, and a gap of 10 mm was reserved on each of the upper side and the lower side as a region for module welding. The surface of the etched conductive glass was sequentially washed twice with acetone and isopropanol, immersed in deionized water for an ultrasonic treatment for 10 min, then dried in a blast drying oven, and then placed in a drying room (with a humidity of less than 2%) to obtain a first electrode.

The washed conductive glass was placed under magnetron sputtering to deposit a layer of nickel oxide as a hole transport layer. The film thickness of the nickel oxide layer was about 15 nm.

A layer of FA_{0.95}Cs_{0.05}PbI₃ perovskite main layer was applied by slit coating to obtain a substrate to be heated, which was then transferred to a vacuum device for evacuation for 60 s with a vacuum degree of 15 Pa. At this time, the closed oven had a solvent atmosphere with a trace amount of N,N-dimethylformamide. Non-contact annealing was performed using a closed oven. The structure of the closed oven was as follows: a. The structure of the closed oven was made up of an upper heating source hot plate and a lower heating source hot plate. The four walls had heat dissipation exhaust holes that could be controlled to open and close and adjust the exhaust rate. The perovskite substrate to be heated was heated upwards, and the upper heating source hot plate and the lower heating source were respectively 30 mm away from the surface of the substrate. b. The structure of a carrier for the substrate to be heated resulted in no contact in the center region of the substrate, and had, only at the four corners, a thermally insulating supporting pin material in contact with the edge of the substrate at 5 mm, such that the substrate to be heated was suspended inside the closed oven.

The annealing process was performed by uniform heating and slow crystallization, followed by annealing at 150°C for 10 minutes to form a light absorption layer with a thickness of about 500 nm.

The above prepared device was placed into a vacuum thermal evaporation device, which was evacuated to 4 × 10-4 Pa, followed by deposition with 30 nm of C60 and 8 nm of BCP as a charge transport layer of the device.

After the charge transport layer was deposited in the vacuum thermal evaporation device, 10 nm of Ag was further deposited on the surface thereof, and then, the device was removed after vacuum breaking, followed by laser etching to form P2. P2 had a width of 150 µm, the etching depth reached the surface of the FTO layer, and the spacing between P2 and P1 was 20 µm. Then, the substrate was placed into the evaporation device again, which was evacuated to 4 × 10⁻⁴ Pa, and then, a layer of Ag was further deposited, with a thickness of about 80 nm.

After being cooled, the device was removed after vacuum breaking and subjected to P-second green laser etching to form P3. P3 had a width of 15 µm, the etching depth reached the surface of the FTO layer, the spacing between P3 and P2 was 20 µm (the position of the etched lines were P1/P2/P3 in sequence).

(3) Edge cleaning: A coating layer in an area extending inward by 0.1 cm from the edge of the solar cell device was cleaned off using a laser marking machine.

(4) Adhesive application: An encapsulation adhesive was applied to the area having undergone edge cleaning.

(5) Lamination: The substrate, the adhesive-applied solar cell device, the encapsulation layer formed with a protective layer, and a cover plate were bonded together and laminated to obtain a solar cell module.

### Embodiments 2-6

These embodiments were different from Embodiment 1 in that the composition of the perovskite used in the light absorption layer was different. The details corresponded to Table 1.

### Comparative Examples 1-3

The manufacturing method of Comparative Examples 1-3 was similar to that of Embodiment 1, except that the annealing was performed by direct contact with a hot plate for annealing at 150°C for 10 minutes, as specifically shown in Table 1.

### Test section

Model Gemini 360 field emission electron scanning microscope from the company Carl Zeiss Jena (ZEISS) was used to photograph the surface morphology of the perovskite layer at 3 KV, with the distance from a lens to the surface of the sample being 4.9-5.1 mm at a magnification of 5 K-10 K. The cross-section was photographed at a magnification of 20K. The cross-sections of the light absorption layers prepared in Embodiments 1-3 were detected, as shown in FIGS. 4-6, and it was found that the grain size distribution of the perovskite compound grains therein was 1-6 µm. As shown in FIG. 7, perovskite compound grains throughout the light absorption layer were found.

Detection of photoelectric conversion efficiency: At room temperature and atmospheric pressure, the volt-ampere characteristic curves of the solar cells manufactured in the embodiments and the comparative examples under light source illumination were measured using an AM1.5G standard light source as a simulated sunlight source by a four-channel digital source meter (Keithley 2440) to obtain the open circuit voltage Voc, the short-circuit current density Jsc, the fill factor FF (Fill Factor), and the energy conversion efficiency Eff (Efficiency) of the solar cell. The test results are as shown in Table 1.

According to Table 1, by comparing the test results of Embodiments 1-10 with Comparative Examples 1-3, it can be seen that in the solar cells provided in the embodiments of the present application, the overall grain size of the perovskite compound grains of the embodiments is larger than the grain size of the comparative examples, which reduces the number of grain boundaries between the perovskite compound grains, reduces or avoids the interference of interface defects, can promote charge separation at the interface, and increases the open circuit voltage of the solar cell, thereby improving the comprehensive performance of the solar cell, including the energy conversion efficiency.

Finally, it should be noted that: the above embodiments are only used to illustrate the technical solution of the present application, but not to limit it; although the present application has been illustrated in detail with reference to the foregoing embodiments, it should be understood by those of ordinary skill in the art that the technical solutions described in the foregoing embodiments may still be modified, or some or all of the technical features thereof may be equivalently substituted; and such modifications or substitutions do not make the essence of the corresponding technical solution depart from the scope of the technical solutions of the embodiments of the present application, and should fall within the scope of the claims and the description of the present application. Especially, as long as there is no structural conflict, the various technical features mentioned in each embodiment can be combined in any way. The present application is not limited to the specific embodiments disclosed herein but includes all the technical solutions that fall within the scope of the claims.

**Table 1 Product parameters and performance parameters of the perovskite solar cells of embodiments and comparative examples (the grains described below are perovskite compound grains).**

| Item | Perovskite compound | Number distributio n of grains with a long diameter of 1-6 µm | Number distribution of grains with a long diameter of 2-5 µm | Number distribution of grains with a long diameter of 1-2 µm | Number distribution of grains with a long diameter < 1µm | Ratio of the grains throughout the light absorption layer to the total number of grains in the cross section | The grains with a long diameter of 1-4 µm are N-gonal, and the value of N | Perovskite annealing method | Jsc | Voc | FF | PCE |
|---|---|---|---|---|---|---|---|---|---|---|---|---|
| | | | | | | | | | (mA/cm² ) | (V) | (%) | (%) |
| Embodimen t 1 | FA_{0.95}Cs_{0.05}PbI₃ | 97.9% | 77.20% | 20.70% | 2.10% | 99.70% | 7-9 | Non-contact closed oven | 22.64 | 1.066 8 | 80.72 | 19.50 |
| Embodimen t 2 | FAPbI₃ | 98.2% | 78.00% | 20.20% | 1.80% | 99.10% | 8-10 | Non-contact closed oven | 23.38 | 1.071 1 | 78.45 | 19.65 |
| Embodimen t 3 | CsPbI₃ | 96.3% | 75.40% | 20.90% | 3.70% | 99.10% | 7-10 | Non-contact closed oven | 19.66 | 1.136 5 | 76.83 | 17.17 |
| Embodimen t 4 | FA_{0.95}Cs_{0.05}SnI₃ | 96.7% | 75.90% | 20.80% | 3.30% | 89.70% | 7-9 | Non-contact closed oven | 16.02 | 1.018 9 | 70.23 | 11.46 |
| Embodimen t 5 | FA_{0.95}Cs_{0.05}Pb_{0.7}Sn_{0.3}I₃ | 98.3% | 80.20% | 18.91% | 0.89% | 88.60% | 6-9 | Non-contact closed oven | 18.77 | 1.050 6 | 72.31 | 14.26 |
| Embodimen t 6 | FA_{0.95}Cs_{0.05}Pb(I_{0.9}Br_{0.1}) 3 | 94.3% | 77.20% | 17.10% | 5.70% | 94.70% | 7-11 | Non-contact closed oven | 20.26 | 1.141 5 | 75.81 | 17.53 |
| Embodimen t 7 | FAPbI₃ | 97.3% | 79.20% | 18.10% | 2.70% | 96.10% | 7-10 | Non-contact closed oven | 22.40 | 1.065 4 | 79.20 | 18.90 |
| Embodimen t 8 | FAPbI₃ | 98.09% | 81.40% | 16.69% | 1.91% | 99.20% | 8-9 | Non-contact closed oven | 23.10 | 1.047 7 | 80.07 | 19.38 |
| Embodimen t 9 | FAPbI₃ | 97.34% | 81.00% | 17.34% | 1.66% | 97.60% | 8-10 | Non-contact closed oven | 22.90 | 1.056 3 | 78.23 | 18.92 |
| Embodimen t 10 | FAPbI₃ | 97.7% | 78.90% | 18.80% | 2.30% | 98.40% | 8-10 | Non-contact closed oven | 23.00 | 1.086 7 | 76.11 | 19.02 |
| Comparativ e Example 1 | FA_{0.95}Cs_{0.05}PbI₃ | 0.80% | 0% | 0.80% | 99.20% | 43.60% | 4-5 | Contact hot plate | 18.44 | 0.901 4 | 64.50 | 10.72 |
| Comparativ e Example 2 | FA_{0.95}Cs_{0.05}SnI₃ | 1.30% | 0% | 1.30% | 98.70% | 11.90% | 4-7 | Contact hot plate | 16.07 | 1.013 0 | 34.73 | 5.66 |
| Comparativ e Example 3 | FA_{0.95}Cs_{0.05}Pb(I_{0.9}Br_{0.1}) 3 | 3.40% | 0% | 3.40% | 96.60% | 22.40% | 4-6 | Contact hot plate | 20.06 | 1.060 5 | 63.98 | 13.61 |

| | | | | | | | | | | | | |
|---|---|---|---|---|---|---|---|---|---|---|---|---|
| **[0181]** Note: In Table 1, FA represents formamidine; Cs represents cesium; Pb represents lead; and I represents iodine. | | | | | | | | | | | | |

## Claims

1. A solar cell, comprising a light absorption layer,
wherein the light absorption layer comprises a plurality of perovskite compound grains, wherein in at least one cross section of the light absorption layer perpendicular to a layer thickness direction, and a number-based cumulative distribution rate of the perovskite compound grains with a long diameter D of 1 µm to 6 µm is ≥ 90%.

2. The solar cell according to claim 1, wherein
in at least one cross section of the light absorption layer perpendicular to the layer thickness direction, the number-based cumulative distribution rate of the perovskite compound grains with a long diameter D of 2.0 µm to 5.0 µm is ≥ 75%;

3. The solar cell according to claim 1 or 2, wherein in at least one cross section of the light absorption layer perpendicular to the layer thickness direction, the number-based cumulative distribution rate of the perovskite compound grains with a long diameter D of 2.0 µm to 3.5 µm is ≥ 50%.

4. The solar cell according to any one of claims 1-3, wherein in at least one cross section of the light absorption layer perpendicular to the layer thickness direction, the number-based cumulative distribution rate of the perovskite compound grains with a long diameter D of more than or equal to 3.5 µm is 5%-30%; and/or
in at least one cross section of the light absorption layer perpendicular to the layer thickness direction, the number-based cumulative distribution rate of the perovskite compound grains with a long diameter D of 2.5 µm to 3.0 µm is ≥ 60%; and/or
in at least one cross section of the light absorption layer perpendicular to the layer thickness direction, the number-based cumulative distribution rate of the perovskite compound grains with a long diameter D of 1.0 µm to 2.5 µm is 20%-40%; and/or
in at least one cross section of the light absorption layer perpendicular to the layer thickness direction, the number-based cumulative distribution rate of the perovskite compound grains with a long diameter D of 1.0 µm to 2.0 µm is 16.69%-20.9%; and/or
in at least one cross section of the light absorption layer perpendicular to the layer thickness direction, the number-based cumulative distribution rate of the perovskite compound grains with a long diameter D of less than or equal to 1.0 µm is ≤ 8%.

5. The solar cell according to any one of claims 1-4, wherein in at least one cross section of the light absorption layer perpendicular to the layer thickness direction, the perovskite compound grains with a long diameter D of 1 µm to 6 µm are polygonal.

6. The solar cell according to any one of claims 1-5, wherein in at least one cross section of the light absorption layer perpendicular to the layer thickness direction, the perovskite compound grains with a long diameter D of 1 µm to 4 µm are N-gonal, wherein N is a positive integer and N is more than 5.

7. The solar cell according to any one of claims 1-6, wherein the light absorption layer comprises perovskite compound grains throughout the light absorption layer in at least one cross section in the layer thickness direction.

8. The solar cell according to claim 7, wherein a ratio of the perovskite compound grains throughout the light absorption layer to a total number of grains in the light absorption layer is 50% to 90%.

9. The solar cell according to claim 7 or 8, wherein the ratio of the perovskite compound grains throughout the light absorption layer to the total number of grains in the light absorption layer is 60% to 85%.

10. The solar cell according to any one of claims 7-9, wherein the perovskite compound grains comprise primary grains and secondary grains, and a number of the secondary grains account for 80%-100% of the total number of the perovskite compound grains.

11. The solar cell according to any one of claims 7-10, wherein the perovskite compound grains comprise primary grains and secondary grains, and a number of the secondary grains account for 65%-95% of the total number of the perovskite compound grains.

12. The solar cell according to any one of claims 7-11, wherein the solar cell comprises a first carrier transport sublayer and a second carrier transport sublayer, and the solar cell comprises:
a passivation layer located between the light absorption layer and the first carrier transport sublayer and/or a passivation layer located between the light absorption layer and the second carrier transport sublayer; wherein the passivation layer is used for reducing defects resulting from the contact of two interfaces.

13. A method for preparing a solar cell, the method comprising:
preparing a light absorption layer comprising a plurality of perovskite compound grains as defined in any one of claims 1-12 by using a non-contact closed annealing container, wherein in at least one cross section of the light absorption layer perpendicular to a layer thickness direction, and a number-based cumulative distribution rate of the perovskite compound grains with a long diameter D of 1 µm to 6 µm is ≥ 90%.

14. The preparation method according to claim 13, wherein the method comprises one or more of the following conditions:
1) the closed annealing container comprises an annealing atmosphere, wherein the annealing atmosphere comprises a polar aprotic solvent; optionally, the polar aprotic solvent comprises at least one of N,N-dimethylformamide, 1-methyl-2-pyrrolidone, dimethyl sulfoxide, and dimethylacetamide;
2) an annealing temperature in the closed annealing container is 100-180°C; and
3) an annealing time in the closed annealing container is 8-30 min.

15. A solar cell module, comprising the solar cell according to any one of claims 1-12 or a solar cell prepared by the preparation method according to claim 13 or 14.

16. An electrical device, comprising the solar cell module according to claim 15, wherein the solar cell module is configured to provide electric energy.
